(19) **Europäisches Patentamt**
**European Patent Office**
**Office européen des brevets**

(11) **EP 2 784 530 B1**

(12) **EUROPEAN PATENT SPECIFICATION**

(45) Date of publication and mention
of the grant of the patent:
**02.03.2016 Bulletin 2016/09**

(51) Int Cl.:
***G01R 33/028*** (2006.01)

(21) Application number: **14161687.0**

(22) Date of filing: **26.03.2014**

(54) **A two axes MEMS resonant magnetometer**

Zweiachsiges MEMS-Resonanzmagnetometer

Magnétomètre résonant MEMS à deux axes

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.03.2013 EP 13161353**

(43) Date of publication of application:
**01.10.2014 Bulletin 2014/40**

(73) Proprietors:
  • **IMEC VZW
    3001 Leuven (BE)**
  • **King Abdulaziz City for Science and Technology
    Riyadh 11442 (SA)**

(72) Inventors:
  • **Farghaly, Mahmoud A.
    3001 Leuven (BE)**
  • **Rochus, Veronique
    3001 Leuven (BE)**
  • **Rottenberg, Xavier
    3001 Leuven (BE)**
  • **Tilmans, Hendricus
    3001 Leuven (BE)**

(74) Representative: **Clerix, André
    IMEC vzw
    IP Department
    Kapeldreef 75
    3001 Leuven (BE)**

(56) References cited:
CN-A- 102 928 793   DE-A1-102010 000 739
US-A- 5 563 343   US-A1- 2009 289 747
US-A1- 2010 295 546

**Description**

**Field**

The present disclosure is related to MEMS resonant magnetometers, in particular to teeter-totter magnetometers actuated by the Lorentz force.

**State of the art**

Magnetometers sensing magnetic fields are used in various applications in industry, in the biomedical field or in consumer electronics as an electronic compass such as in mobile phones. For many of these applications, magnetometers should be sufficiently compact to reduce footprint.

Microelectromechanical technology (MEMS) allows manufacturing compact magnetometers. These MEMS magnetometers can be operated using the Hall effect, the magnetoresistance effect or the Lorentz Force.

The Hall-based magnetometers exhibit a large hysteresis, have a smaller sensitivity and are difficult to integrate with other MEMS devices and/or semiconductor devices. Magnetometers using the magnetoresistance effect to sense the magnetic field require dedicated magnetic materials, suffer from larger power consumption and are also difficult to integrate. Lorentz Force based magnetometers offer a sufficiently high sensitivity and low power consumption and can be easier integrated.

Lorentz Force based MEMS magnetometers have a conductor that deflects in response to the interaction between an electrical current flowing through the conductor and an external magnetic field in which the conductor is placed. The direction and the magnitude of the deflection depend on the direction and the magnitude of this electrical current and the external magnetic field present.

Several research efforts have been put in developing a multi-axes MEMS magnetometer for use in motion tracking units or Inertial Measurements Units (IMUs) or are used as aided-backup navigation system if GPS is either unavailable or unreliable. Typically such multi-axis MEMS magnetometers are composed of several single axis MEMS magnetometers, whereby each magnetometer is positioned to sense the magnetic field along a particular axis.

Li et al discloses in "Three-Axis Lorentz-Force Magnetic Sensor for Electronic Compass Applications" IEEE journal of microelectromechanical systems, vol.21, No. 4, august 2012, a magnetometer allowing in a single MEMS structure two-axis magnetic field measurement using Lorentz Force. The MEMS device disclosed however has a considerable footprint. Manufacturing is complex as the device is composed of several layers. Its sensitivity is limited as sensing of the magnetic field in one orthogonal direction is done using differential capacitive measurement while in the other orthogonal direction a single pick-off electrode is used.

Hence there is a need for a compact MEMS-based resonant magnetometer using Lorentz Force that allows measuring magnetic fields along more than 1 axis. This magnetometer should allow simpler manufacturing and yield a higher sensitivity when measuring magnetic fields.

**Summary**

A two axes MEMS resonant magnetometer is disclosed comprising in one plane a freestanding rectangular frame having inner walls and 4 torsion springs, wherein opposing inner walls of the frame are contacted by one end of only 2 springs, each spring being anchored by its other end to a substrate. This torsion spring can be e.g. an L-shaped spring, a folded beam spring or serpentine spring.

The substrate of this magnetometer may comprise two electrically isolated power supply lines whereby the diagonally facing anchored ends are electrically connected to the same power supply line.

On this substrate 4 sensing electrodes can be present whereby each electrode is capacitively coupled to a different side of the frame.

The rectangular frame and the torsion springs of this magnetometer are preferably formed of the same material. This material is selected to have low electrical resistivity to obtain low power consumption, low Young's modulus to be less stiff and increase sensitivity and low stress gradient and residual stress to avoid buckling and sensor failure. It can be metals, e.g. Aluminium, copper or nickel or silicon compounds, e.g. silicon germanium.

The disclosure is in particular related to a MEMS magnetometer comprising in one plane a rectangular frame having inner walls and 4 torsion springs, the end of one leg of each torsion spring being attached to an inner wall, whereby opposing inner walls are contacted by only 2 springs, while the end of the other leg of each spring is anchored, in case of a L-shaped springs, towards the centre of the frame, to a substrate having two power supply lines whereby diagonally facing anchored ends are electrically connected to the same power supply line.

A method for designing a MEMS magnetometer, according to the foregoing paragraphs, is disclosed. The method comprises dimensioning the frame and the torsion springs to maximize the sensitivity of the differential capacitive measurement between opposite capacitors while minimizing the cross-sensitivities of the differential capacitive measurement between adjacent capacitors.

A method for operating a MEMS magnetometer according to the foregoing paragraphs is disclosed. The method comprises placing the MEMS magnetometer in a magnetic field, applying an AC voltage between the two power supply lines, the AC voltage having a frequency equal to the frequency of at least one of the two orthogonal modes of the MEMS magnetometer, thereby creating a current flowing between opposite biased anchored ends, measuring the differential capacitance between the opposite capacitors corresponding to the orthogonal mode, and determining from this differential capacitance an in-plane component of the magnetic field.

## Brief description of the figures

Figure 1 shows a schematic view of a magnetometer according to this disclosure.

Figure 2 shows a schematic top view of the magnetometer shown in figure 2 identifying the dimensions thereof.

Figure 3 shows a schematic view of a magnetometer having folded beam torsion springs according to this disclosure.

Figure 4 shows a schematic view of a magnetometer having serpentine beam torsion springs according to this disclosure.

Figure 5 plots the sensitivities $S_{xx}$ and $S_{yy}$ for different values of a and $\beta$ according to an example of this disclosure.

Figures 6a-b shows COMSOL simulation of relative sensitivities $S_{xx}$ (4a) and $S_{yy}$ (4b) versus frequency with the sensing mode shape for the design example of this disclosure.

Figure 7 shows a schematic cross section of the magnetometer shown in figure 1.

Figure 8 shows an electrical equivalent circuit of the magnetometer shown in figure 1 for the two in-plane components of the magnetic field.

Figures 9a-b show the amplitude plot of the S-parameters of the equivalent circuit of the magnetometer shown in figure 1.

Figures 10a-b show the polar plot of the S-parameters of the equivalent circuit of the magnetometer shown in figure 1.

## Detailed description

The present disclosure will be described with respect to particular embodiments and with reference to certain drawings but the disclosure is not limited thereto. The drawings described are only schematic and are nonlimiting. In the drawings, the size of some of the elements may be exaggerated and not drawn on scale for illustrative purposes. The dimensions and the relative dimensions do not necessarily correspond to actual reductions to practice of the disclosure

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present disclosure, the only relevant components of the device are A and B.

The disclosed magnetometer **1** is a two-axes resonant magnetometer using a single MEMS structure. In addition, it uses differential capacitive sensing for detecting the two in-plane components of the magnetic field. The disclosed design is utilizing area in a very efficient way resulting in a smaller footprint. This compact design is achieved by bringing the supporting beams, i.e. the springs **5,6,7,8**, inside the freestanding frame **2**. Hence the springs **5, 6, 7, 8** and the frame **2** are within the same plane, except for the anchoring **5b,6b,7b,8b** of the springs to the substrate **9**. Hence the springs and the frame can be formed of the same conductive material, preferably metal. Finally, the levels of cross coupling between adjacent capacitors, i.e. sensing electrodes **12,13,14,15**, for the different magnetic field components are minimized by employing differential capacitive measurement or sensing and operating the device in orthogonal mode shapes.

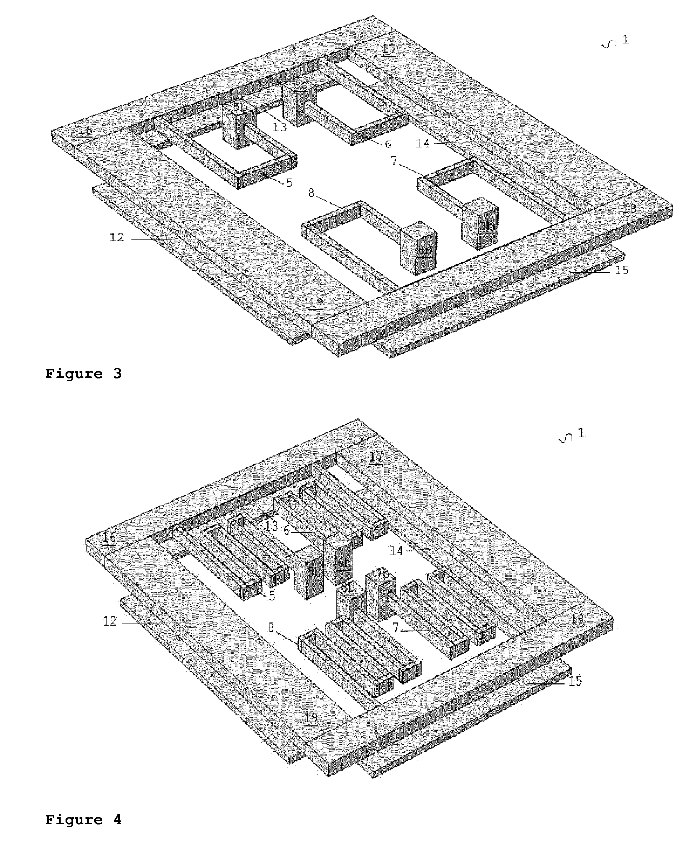

This torsion spring can be e.g. an L-shaped spring, a folded beam spring as shown in figure 3 or serpentine spring as shown in figure 4. The layout of the spring can be selected in view of the sensitivity and stiffness. A serpentine spring will be less stiff and more sensitive than a L-shaped spring. For the purpose of teaching the disclosure, L-shaped springs were used.

**Principle of Operation**

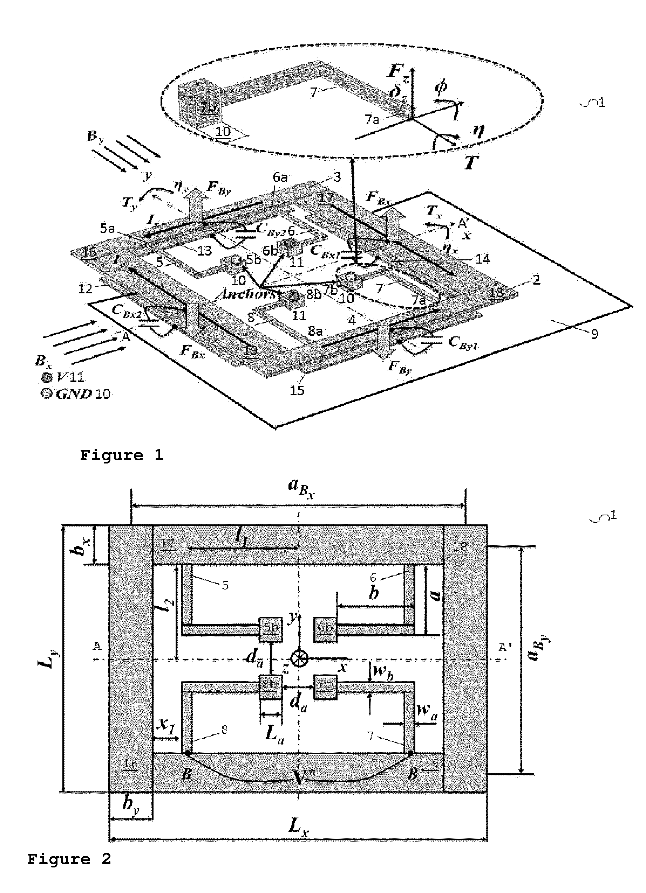

As shown in figure 1, the proposed resonant magnetometer **1** is a seesaw (or teeter-totter) plate or frame **2** that is held by four, here L-shaped, torsion springs **5,6,7,8** anchored at one end **5b,6b,7b,8b** to a substrate **9** and at their other end **5a,6a,7a,8a** to an inner wall **3,4** of the frame **2** such that opposing inner walls **3,4** are only contacted by two springs. Bringing the springs inside the seesaw plate or frame **2**, makes the magnetometer compact, thereby occupying a relatively small area. The configuration of the springs enables the microstructure to rotate around x-axis and y-axis with angles $\eta_x$ and $\eta_y$, respectively. The magnetic field components $B_x$ and $B_y$ can be measured this way.

The principle of operation is based on Lorentz Force $\vec{F}=L\vec{I}\times\vec{B}$, acting on a current I-carrying conductor with length L when placed in a magnetic field B. As shown in figure 1, an AC voltage difference V, with a frequency preferably equal to the microstructure resonance frequency of the sensing mode in which the device operates, is applied between directly facing anchors, **5b** and **7b** or **6b** and **8b**, with a configuration that creates opposite current $I_x$ and $I_y$ on opposite sides of the frame **2**. This voltage difference is created by connecting directly facing anchors, **5b and 6b** or **7b and 8b**, to different power lines **10,11** present on the substrate **9**.

As a result, equal and opposite forces $\mathbf{F_{Bx}} \approx \mathbf{B_x.I_y}.2.\mathbf{l}_1.$ and $\mathbf{F_{By}} \approx \mathbf{B}y.\mathbf{I_x}.2.\mathbf{a_{By}}$ acting on opposite sides of the frame **2** are created. The dimensions of the frame **2** are shown in figure 2. These forces generates torques $\mathbf{T_y} \sim \mathbf{F_{Bx}}.\mathbf{a_{By}}$ and $\mathbf{T_x} \sim \mathbf{F_{By}}.\mathbf{a_{Bx}}$ which make the frame **2** rotate around x-axis and y-axis, respectively. Hence the magnetometer senses the magnetic field in two orthogonal axes.

This rotational movement is translated into a capacitance change because each side **16,17,18,19** of the seesaw frame is one of two electrodes of a parallel plate capacitor. The other electrode **12,13,14,15** is fixed on the substrate **9** and is capacitively coupled to the corresponding side **16,17,18,19** of the frame. Figure 1 illustrates the location of the 4 capacitors, $C_{By1}$ (**15,18**), $C_{By2}$ (**13,16**), $C_{Bx1}$ (**14,17**) and $C_{Bx2}$ (**12,19**), formed between the electrodes on the substrate and the sides of the frame. Each pair of capacitors will measure the rotation of the seesaw frame around one axis: the pair $C_{By1}$ (**15,18**) and $C_{By2}$ (**13,16**) around the y-axis, the pair $C_{Bx1}$ (**14,17**) and $C_{Bx2}$ (**12,19**) around the x-axis.

Capacitors at opposite positions, $C_{Bx1}$ $C_{Bx2}$ and $C_{By1}$ $C_{By2}$, of the frame **2** along this axis will yield an opposite capacitance signal. This capacitance change $\Delta C_{Bi}$, either $C_{Bx1}$-$C_{Bx2}$ or $C_{By1}$-$C_{By2}$, is differential due to the opposite movement of opposite sides **19,17** and **16,18** of the seesaw frame. Hence the differential capacitance is measured between opposite capacitors. This capacitance change is proportional to the value of the magnetic field components $B_x$ and $B_y$, respectively.

In order to have the largest differential capacitance change $\Delta C_{Bi}$, the external AC voltage difference V applied over a pair of anchors (**5b,6b** or **7b,8b**), each connected to another power supply line **10,11**, of the torsion springs should be set to a frequency equal to the microstructure resonant frequency of the respective $B_x$ and $B_y$ sensing modes. This enhances the mechanical response of the frame by the mechanical quality factor Q.

**Design Approach**

As an example, the design of such a magnetometer is to fit a chip area less than 250 $\mu$m (micrometer) by 300$\mu$m. Some dimensions are chosen constant or have upper limits and they are listed in table 1. The other dimensions (e.g. $l_1, l_2$,...) will be chosen based on optimization criteria for achieving equal (and maximal) relative sensitivities $S_{xx}$ and $S_{yy}$ in x and y directions, respectively.

Table 1: dimensions for the device shown in figure 2

| Dimension | Value | Constaint |
|---|---|---|
| $L_a$ | 15[$\mu m$] | - |
| $x_1$ | 10[$\mu m$] | - |
| $w_a = w_b$ | 4[$\mu m$] | Equal to thickness(t) |
| $d_a$ | 20[$\mu m$] | Minimizing feedthrough |
| $L_y$ | < 250[$\mu m$] | chip area |
| $L_x$ | < 300[$\mu m$] | chip area |

The relative sensitivity is the figure of merit that is used to judge on the performance of the magnetometer. The relative sensitivity in j[th] direction due to a magnetic field component in ith direction (i,j refers to either x or y direction) is defined as follows:

$$S_{ij} = \frac{1}{C_{0_{B_j}}} \frac{\partial \Delta C_{B_j}}{\partial B_i} = \frac{1}{C_{0_{B_j}}} \frac{\partial \Delta C_{B_j}}{\partial w} \cdot \frac{\partial w}{\partial \eta_j} \cdot \frac{\partial \eta_j}{\partial T_j} \cdot \frac{\partial T_j}{\partial B_i} \quad (1)$$

When (i=j=x or y) in the above equation (1), it represents the relative sensitivities $S_{xx}$ and $S_{yy}$ due to magnetic field components $\mathbf{B_x}$ and $\mathbf{B_y}$, respectively. When (i ≠j) in the above equation (1), it represents cross sensitivities $S_{xy}$ and $S_{yx}$ between the two axes. The four terms in equation (1) are further discussed below.

The first term in equation (1) is the change in differential capacitance due to electrode displacement $\mathbf{w}$ in z direction. For a capacitance with an electrode area $A_{ei}$, it can be expressed as:

$$\frac{1}{C_{0_{B_j}}} \frac{\partial \Delta C_{B_j}}{\partial w} = \frac{1}{C_{0_{B_j}}} \frac{2\varepsilon_0}{d_0^2} \iint_{A_{e_i}} \frac{1 + (w/d_0)^2}{(1 - (w/d_0)^2)^2} dx dy \quad (2)$$

where $C_{0Bj} = \varepsilon_0 A_{ei}/d_o$ and $\mathbf{d_o}$ is the gap in steady state, i.e. the distance between a side of the frame and the corresponding electrode on the substrate **9** when the frame **2** is parallel to the substrate **9**. Assuming small deflections compared to the gap $d_o$, equation (2) converges to $2/d_o$.

The second term in equation (1) reflects the change in electrodes' vertical displacement due to the rotation angle caused by the torque exerted on the frame **2**. For small rotation angles, this term can be expressed as follows:

$$\partial w/\partial \eta_y = (l_1 + w_a/2 + x_1 + b_y/2) = 0.5 a_{B_x} \qquad (3a)$$

$$\partial w/\partial \eta_x = (l_2 + b_x/2) = 0.5 a_{B_y} \qquad (3b)$$

where $a_{Bi}$ is the average torque arm when the component $B_i$ is responsible for the rotation of the frame.

The third term in equation (1) represents the transfer function between the rotation angle $\eta_j$ and the exerted torque $\mathbf{T_j}$. Considering the system as a single degree of freedom (SDOF) system, the transfer function is as follows:

$$\partial \eta_j/\partial T_j = \frac{K_{\eta_j \eta_j}^{-1}}{\sqrt{(1 - (\omega/\omega_{0j})^2)^2 + (Q^{-1}\omega/\omega_{0j})}} \quad (4)$$

where Q is the quality factor (e.g, Q = 1000), $\omega_{0j}$ is the radial angular frequency of the resonant sensing mode when rotating around the $j_{th}$ axis and $K_{\mathbf{njnj}}$ is the rotational stiffness for the whole structure when it rotates around the $j_{th}$ direction. Rotational stiffness $K_{njnj}$ is a function of the stiffness matrix elements of the torsion spring.

Using Castigliano's principle, the stiffness matrix that relates the out-of-plane displacements $\delta_{\mathbf{z}}$, $\phi$ and $\eta$ with force $\mathbf{F_z}$ and moments $\mathbf{M}_\phi$ and $\mathbf{T}$ acting on the free guided segment of a spring as shown in the insert of figure 1 can be deduced. These parameters are related through stiffness matrix as follows:

$$\begin{bmatrix} F_z \\ M_\phi \\ T \end{bmatrix} = \begin{bmatrix} k_{zz} & k_{z\phi} & k_{z\eta} \\ & k_{\phi\phi} & k_{\phi\eta} \\ sym. & & k_{\eta\eta} \end{bmatrix} \begin{bmatrix} \delta_z \\ \phi \\ \eta \end{bmatrix} \quad (5)$$

Each element of the stiffness matrix is function of the material properties (Young's modulus E, shear modulus G) and the geometry of the torsion spring ($\beta = \mathbf{b/a,a,w_a,w_b}$). Expressions of array elements stiffness matrix are used to obtain the rotation stiffness for the whole structure around the x and the y axis. This can be done by considering one quarter of the whole structure, construct the free-body-diagram, write the moment equilibrium equations and geometrical constraints and substitute from equation (5) in the moment equilibrium equations.

Stiffnesses of the whole structure can be expressed as follows:

$$K_{\eta_y \eta_y} = T_y/\eta_y = 4(k_{\eta\eta} + 2k_{z\eta}l_1 + k_{zz}l_1^2) \qquad (6a)$$

$$K_{\eta_x \eta_x} = T_x/\eta_x = 4(k_{\phi\phi} + 2k_{z\phi}l_2 + k_{zz}l_2^2) \qquad (6b)$$

The fourth term in equation (1) represents the torque-magnetic field relation. It is the multiplication of the current through, the length of this current carrying conductor and the torque arm. It can be expressed as follows:

$$\partial T_y/\partial B_x = I_y \cdot a_{B_x} \cdot 2(l_2 + b_x/2) \qquad (7a)$$

$$\partial T_x/\partial B_y = I_x \cdot a_{B_y} \cdot 2(l_1 + w_a/2) \qquad (7b)$$

where

$$I_y = \frac{V^*}{0.5R_{s_y}} = \frac{2V^*}{\frac{2(l_2+b_x/2)}{\sigma b_y}t}, I_x = \frac{V^*}{0.5R_{s_x}} = \frac{2V^*}{\frac{2(l_1+w_a/2)}{\sigma b_x}t}$$

where V* is the voltage between points **B** and **B'** as shown in figure 2. The factor 0.5 is due to the fact that the voltage **V** is applied over two similar parallel branches. This makes the resistance seen by a current $I_x$ or $I_y$ half the resistance of one electrode. Expressing the torque-magnetic field in terms of voltage **V\*** make it possible to express sensitivities either in $l_1$ or $l_2$ but not together. This simplifies their formula to be optimized.

At the resonance frequency of sensing mode, the sensitivities $S_{xx}$ and $S_{yy}$ are proportional to:

$$S_{xx} \propto QK_{\eta_y \eta_y}^{-1} \cdot (l_1 + x_1 + w_a/2 + b_y/2)^2 \cdot b_y \qquad (8a)$$

$$S_{yy} \propto QK_{\eta_x \eta_x}^{-1} \cdot (l_2 + b_x/2)^2 \cdot b_x \qquad (8b)$$

The chip area and the spacing between the anchors impose geometrical constraints on the dimensions $l_1$, $l_2$, $b_x$ and $b_y$ of the frame **2** shown in figure 2. These constraints are indicated by $G_{l1U}$, $G_{l1U}$ and $G_{by}$ and further explained in table 2. Table 3 list material properties for the frame and the springs when made of silicon-germanium. Each of the dimensions $l_1$ and $l_2$ has an upper and lower limit so as not invoke those constraints.

Table 2: geometrical constraints on dimensions of the frame $l_1$, $L_2$, $b_x$ and by.

| Dimension | Constraint | Constraint formula |
|---|---|---|
| $l_1$ | $G_{l_1L}$ | >= b + [$d_a$/2 + $L_a$ - $w_a$/2]<br>>= βa + 23[$\mu m$] |
| | $G_{l_1U}$ | <= ($L_x$/2 - $w_a$/2 - $x_1$ - $b_y$)<br><= (138[$\mu m$] - $b_y$) |

(continued)

| Dimension | Constraint | Constraint formula |
|---|---|---|
| $l_2$ | $G_{l2L}$ | $>= a + [d_a/2 + L_a/2 - w_b/2]$ <br> $>= a + 15.5[\mu m]$ |
| | $G_{l2U}$ | $<= (L_y/2 - b_x)$ <br> $<= (125[\mu m] - b_x)$ |
| $b_y$ | $G_{byU}$ | $<= 115[\mu m] - \beta a$ |
| $b_x$ | $G_{bxU}$ | $<= 109.5[\mu m] - a$ |

Table 3: material properties of silicon germanium and gap height used during simulation

| $E[GPa]$ | $\nu$ | $\rho[kg/m^3]$ | $\rho_e[\Omega m]$ | $d_0[\mu m]$ |
|---|---|---|---|---|
| 120 | 0.22 | 4557 | $7 \times 10^{-6}$ | 3 |

To find the equal (and maximal) relative sensitivities, the insight provided by equations (8a, 8b) is used. These equations teach that $\mathbf{b}_x$ and $\mathbf{b}_y$ should be maximized and the dimensions $\mathbf{l}_1$ and $\mathbf{l}_2$ should be minimized. The locus of the maximum values for $\mathbf{b}_y$ and $\mathbf{b}_x$ is obtained when meeting the constraints ($G_{l1L}$ and $G_{l1U}$) and ($G_{l2L}$ and $G_{l2U}$), respectively.

The maximum of $S_{xx}$ and $S_{yy}$ is at the intersection of constraints ($G_{byU}$, $G_{l1U}$ and $G_{l1U}$) and ($G_{bxU}$, $G_{l2U}$ and $G_{l2U}$), respectively. However, the relative sensitivities $S_{xx}$ and $S_{yy}$ at the intersection may not be equal to each other. The smaller of the two will be the best achievable sensitivity at the specific value of $\beta$ and $\mathbf{a}$.

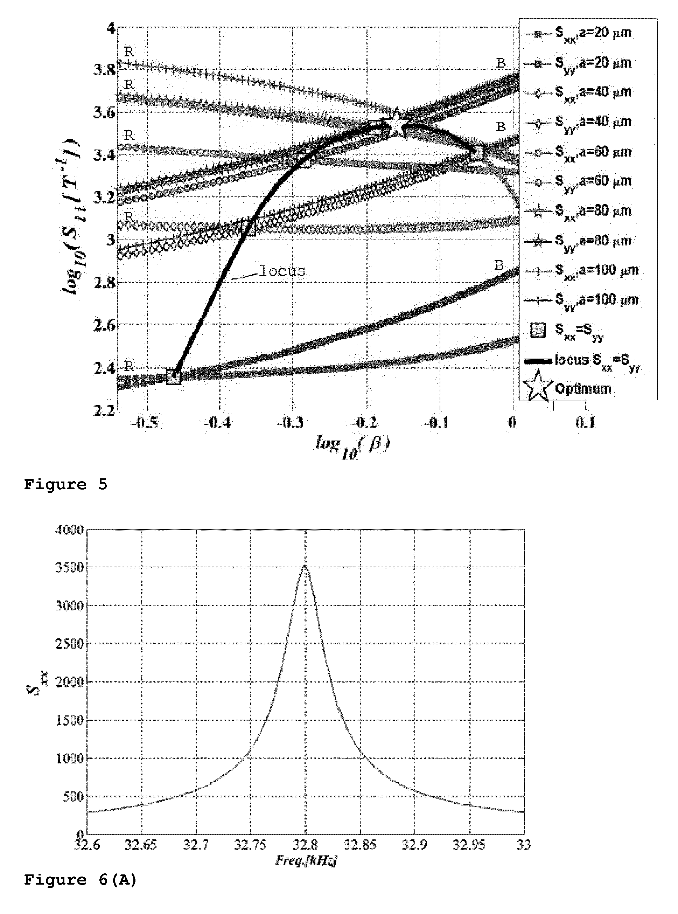

As shown in figure 5, a sweep on different values for $\beta$ and $\mathbf{a}$ was made to obtain values for which maximal and equal sensitivities are obtained. Each point on a red curve **R** and a blue curve **B** represent the maximum of $S_{xx}$ and $S_{yy}$ as discussed in before. Their intersection (**squares**) is the point of equal sensitivity. The locus of equal sensitivities is represented by the black curve. The maximal (and equal) sensitivity will be the maximum of that black curve (**star**). The optimum dimensions in this design example are a = 85$\mu$m, $\beta$=0.69, $l_1$ = 81.96$\mu$m, $l_2$ = 100.5$\mu$m, $b_y$ = 56.04$\mu$m and $b_x$ = 24.5$\mu$m. This corresponds to an (average) relative sensitivity $S_{xx} \sim S_{yy} \sim 3471[T^{-1}]$.

## FEM simulations

FEM simulations using COMSOL were made to study the performance of the magnetometer. This was done by applying distributed opposite forces in the z direction, simulating Lorentz forces $F_{Bx}$ and $F_{By}$, on the opposite sides of the frame **2**. To calculate the sensitivities, equation (1) was used. All terms can be easily evaluated through integration and averaging on moving domains.

The third term of equation (1) involves calculating torsional stiffness, can be calculated through transformation of the stiffness in the z direction ($F_z/\delta_z$) into a torsional stiffness $(F_z/\delta_z) a_{Bi}^2 / 2$ with $a_{Bi}$ being the average length of the torque arm.

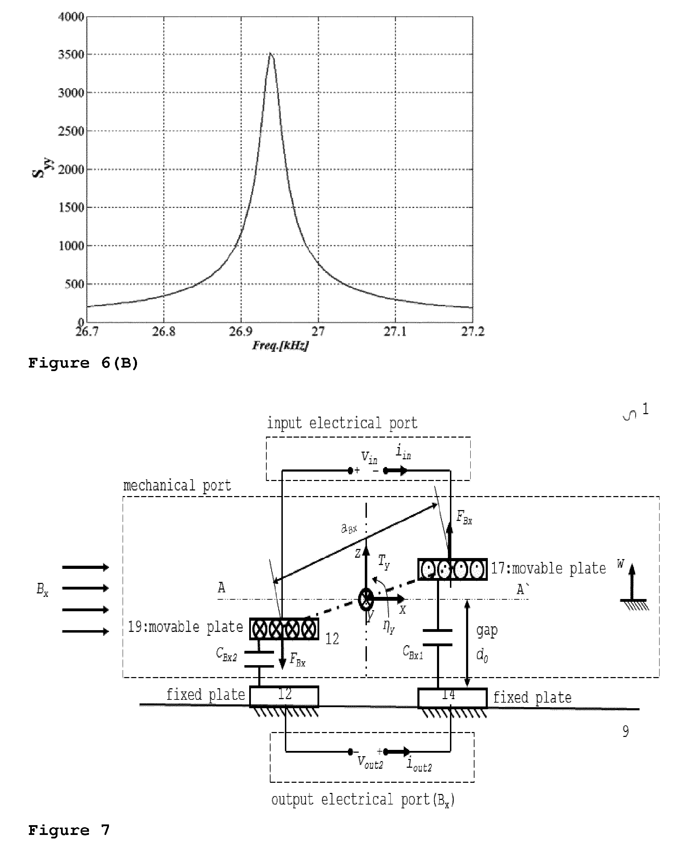

A stationary FEM simulations using Solid mechanics, with the optimum dimensions derived above, showed that the sensitivities $S_{xx}$ and $S_{yy}$ are not equal: $S_{xx} \approx 4042 [T^{-1}]$ and $S_{yy} \approx 3547 [T^{-1}]$. To remedy this, one of the dimensions ought to be seized down. Reducing $b_y$ from 56.04$\mu$mto about 51.3$\mu$m, yields nearly equal sensitivities $S_{xx} \approx 3550[T^{-1}]$ and $S_{yy} \approx 3547 [T^{-1}]$, as shown in figures 6a and 6b respectively.

The cross sensitivities are as minimum as possible by employing differential capacitive sensing and operating the device in orthogonal sensing mode shapes.

The difference in values between the sensitivity values between analytical model and FEM is due to the fact that equation (6) was found to overestimate the stiffness, compared to FEM. However, the reduced $b_y$ was 9% off the predicted value by the analytical model.

## Equivalent Circuit

Equivalent circuit has been an effective tool to map all different energy domains in a multi-physics system like MEMS to the electrical domain. Equivalent circuits are developed starting from the first law of thermodynamics (conservation of energy) assuming lossless systems and equations of equilibrium for the different energy domains. However, this equivalency is conditioned by the linearity around the biasing point. As a simplification, only the electrical and mechanical energy domains are considered when developing the equivalent circuit of the magnetometer described above. Each energy domain is represented by a port that is fully described by two state variables (flow and effort).

Figure 7 shows that the magnetometer system has two electrical ports and one mechanical port. Energy exchange between input electrical port and mechanical ports can be represented by an electrodynamic subtransducer. As a result of this energy exchange, states of the output electrical port change. This energy exchange can be presented by electrostatic sub-transducer.

The system can be broken into an electrodynamic sub-transducer and an electrostatic subtransducer.

The electrodynamic transducer accounts for the energy exchange between input electrical port ($v_{in}$, $q_{in}$) and the mechanical port (w, $F_{Bi}$). The ABCD matrix of an electrodynamic transducer held by no spring and involving translation motion in the z direction, is as follows:

$$
\begin{bmatrix} v_{in} \\ i_{in} \end{bmatrix} = \begin{bmatrix} \frac{j\omega L_{s_i}}{\Psi_{B_i}} & \Psi_{B_i} \\ \Psi_{B_i} & 0 \end{bmatrix} \begin{bmatrix} F_{B_i} \\ -w \end{bmatrix}
$$
$$
= \begin{bmatrix} 1 & j\omega L_{s_i} \\ 0 & 1 \end{bmatrix} \begin{bmatrix} 0 & \Psi_{B_i} \\ 1/\Psi_{B_i} & 0 \end{bmatrix} \begin{bmatrix} F_{B_i} \\ -w \end{bmatrix}
\qquad (9)
$$

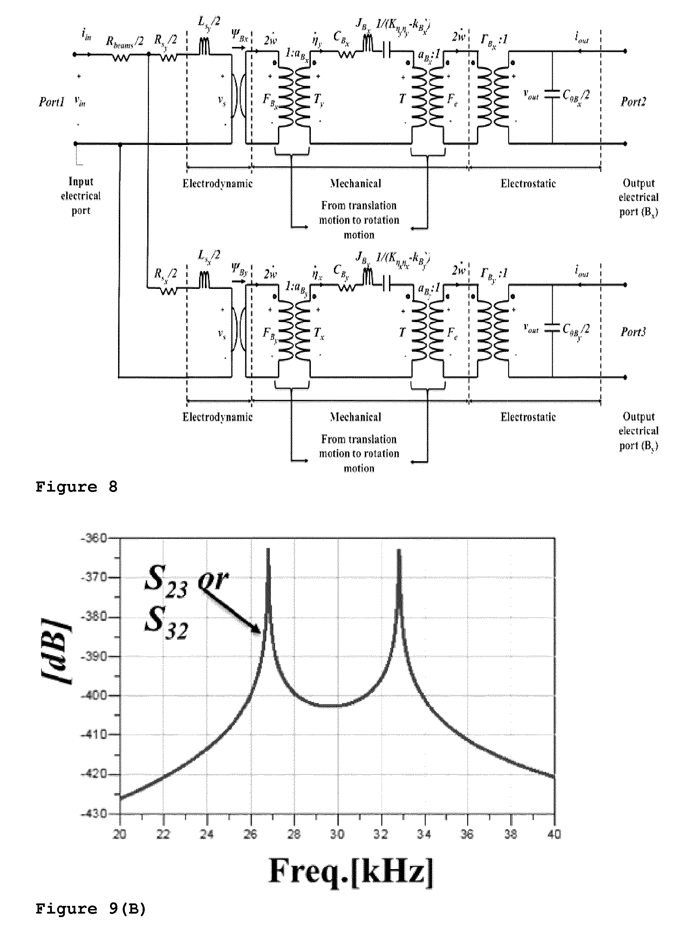

where $L_{si}$ and $\Psi_{bi}$ are the self-inductance of the conductor lying in the $i^{th}$ direction and the magnetic transduction factor for the $B_i$ component respectively. This subtransducer represents the input port as shown in figure 8.

The electrostatic transducer accounts for the energy exchange between the mechanical port (w, $F_e$) and the output electrical port ($v_{out}$, $q_{out}$). The ABCD matrix of an electrostatic transducer held by an spring $K_{spr} = K_{\eta_i \eta_i}/a_{Bi}^2$ and involving translation motion in z direction, is as follows:

$$
\begin{bmatrix} v_{out} \\ i_{out} \end{bmatrix} = \begin{bmatrix} \frac{1}{\Gamma_{B_i}} & \frac{1}{j\omega \Gamma_{B_i}}(K_{spr} - k'_{B_i}) \\ \frac{j\omega C_{0_{B_i}}}{2\Gamma} & \frac{K_{spr} C_{0_{B_i}}}{2\Gamma} \end{bmatrix} \begin{bmatrix} F_e \\ -w \end{bmatrix}
$$
$$
= \begin{bmatrix} 1 & 0 \\ \frac{j\omega}{2} C_{0_{B_i}} & 1 \end{bmatrix} \begin{bmatrix} \frac{1}{\Gamma_{B_i}} & 0 \\ 0 & \Gamma_{B_i} \end{bmatrix} \begin{bmatrix} 1 & \frac{1}{j\omega}(K_{spr} - k'_{B_i}) \\ 0 & 1 \end{bmatrix} \begin{bmatrix} F_e \\ -w \end{bmatrix}
\qquad (10)
$$

where $\Gamma_{Bi}$ and $K'_{Bi} = \Gamma^2/C_{0Bi}$ are the electrical transduction factor for $B_i$ and the spring constant due to softening effect, respectively. The capacitance at the output port was reduced by a factor of 2 because the differential capacitances appear as if they are connected in series. This sub-transducer represents the output port as shown in figure 6.

The proposed magnetometer is based on torsion. It is considered a rotary system. The developed equivalent circuit is for translation systems. So, a transformation is needed that links the translation movement of electrodes in the z direction to the rotation $\eta_i$. This linking can be done through the following equations:

$$
T_j = a_{B_i} F_{B_i} \qquad (11a)
$$

$$
\eta_j = 1/a_{B_i}(2w) \qquad (11b)
$$

These equations can be presented by a transformer with turns ratio (1:$a_{Bi}$). As shown in figure 8, this transformation is used twice to transform the translation motion ($F_{Bi}$, w) into a rotary motion ($T_j$, $\eta_j$).

**Simulation of the equivalent circuit**

Table 4 lists values and expressions for circuit elements for sensing circuits of magnetic field components $B_x$ and $B_y$.

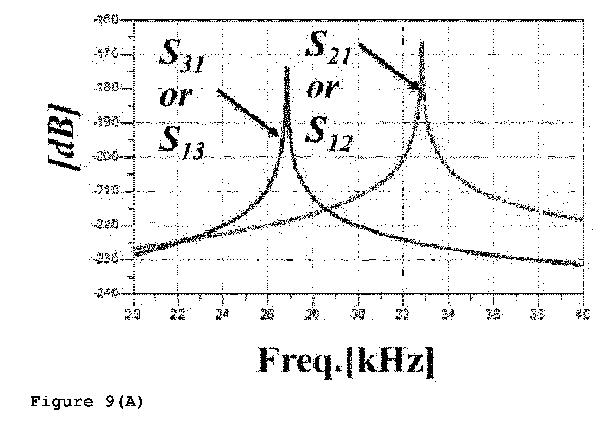

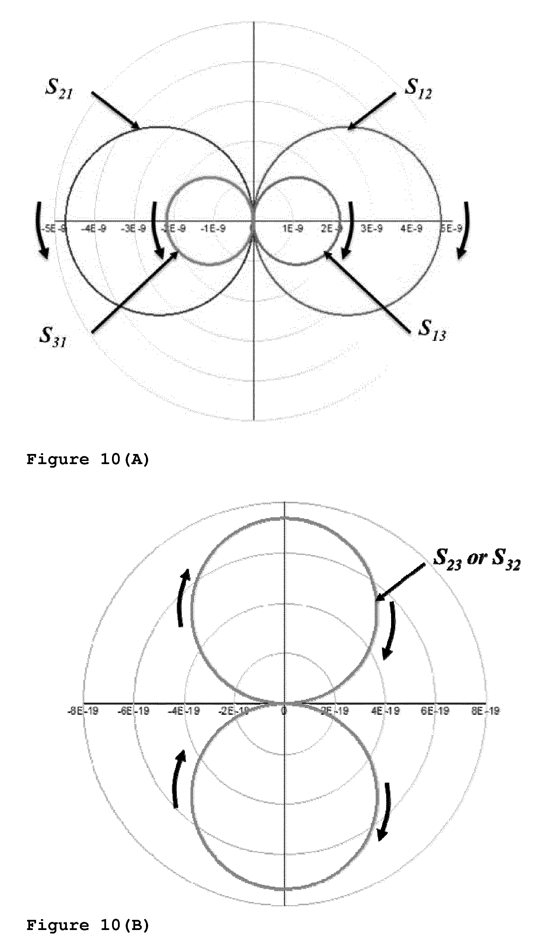

Figures 9a-b and 10a-b shows Advanced Design Simulation of the equivalent circuit of the magnetometer using a bias voltage $V_b = 1V$ and magnetic fields $B_x = B_y = 60\mu$Tesla. Simulations show that scattering parameters $S_{12}$ (representing gain for sensing $B_x$) and $S_{13}$ (representing gain for sensing $B_y$) have different resonance frequency, which works in favor of isolating $B_x$ and $B_y$ sensing circuits. Besides, $S_{23}$ and $S_{32}$ (represent cross-sensitivities between sensing ports for $B_x$ and $B_y$) have very low amplitude levels compared to $S_{21}$ and $S_{31}$, indicative of the improved self sensitivity of the disclosed device for $B_x$ and $B_y$ due to being less dependent on the other normal in-plane component.

Table 4: values and expressions of circuit elements for sensing $B_x$ and $B_y$.

| Variable | Expression | Value |
|---|---|---|
| $J_{B_x}$ | $\frac{\rho t}{12}\left[L_x L_y^3 - (L_x - 2b_y)(L_y - 2b_x)^3\right]$ | $7.28[akg\cdot m^2]$ |
| $R_{s_y}$ | $2(l_2+b_x/2)/(\sigma b_2 i)$ | $7.69[\Omega]$ |
| $\Psi_{Bx}$ | $B_x \cdot 2(l_2+b_x/2)$ | $13{,}5[nA/N]$ |
| $K'_{B_x}$ | $\Gamma_{B_x}^2 a_{B_x}{}^2 / C_{0B_x}$ | $0.24[nN.m]$ |
| $\Gamma_{Bx}$ | $\varepsilon_0 A_{ey} V_b / d_0^2$ | $12.6[nN/V]$ |
| $C_{Bx}$ | $\omega_{0y} J_{Bx}/Q$ | $1.5[fN/rad]$ |
| $L_{s_x}$ | COMSOL | $\approx 0[H]$ |
| $\omega_{0y}$ | COMSOL | $2.06 \times 10^5 [rad/s]$ |
| $C_{0B_x}$, | $\varepsilon_0 A_{ey}/d_0$ | $37.8[fF]$ |
| $K_{\eta_x\eta_y}$ | $\omega_{0y}^2 J_{Bx}$ | $3.1E{-}7[N.m]$ |
| $a_{Bx}$ | Eq.(3a) | $239.2[\mu m]$ |
| $R_{beams}$ | $\frac{\rho_e}{t}(a/w_a + b/w_b)$ | $62.98[\Omega]$ |
| $J_{By}$ | $\frac{\rho t}{12}\left[L_y L_x^3 - (L_y - 2b_x)(L_x - 2b_y)^3\right]$ | $4.58[akg.m^2]$ |
| $R_{s_x}$ | $2(l_1 + w_a/2)/(\sigma b_1 t)$ | $11.99[\Omega]$ |
| $\Psi_{By}$ | $B_y \cdot 2(l_1 + w_a/2)$ | $10[nA/N]$ |
| $K'_{B_y}$ | $\Gamma_{B_y}^2 a_{B_y}{}^2 / C_{0B_y}$ | $10.7[nN.m]$ |
| $\Gamma_{By}$ | $\varepsilon_0 A_{ex} V_b / d_0^2$ | $7[nN/V]$ |
| $C_{By}$ | $\omega_{0x} J_{By}/Q$ | $0.76[fN/rad]$ |
| $L_{s_y}$ | COMSOL | $\approx 0[H]$ |
| $\omega_{0x}$ | COMSOL | $1.69 \times 10^5 [rad/s]$ |
| $C_{0B_y}$ | $\varepsilon_0 A_{ex}/d_0$ | $21 [fF]$ |
| $K_{\eta_x\eta_x}$ | $\omega_{0x}^2 J_{By}$ | $1.3E{-}7[N,m]$ |
| $a_{By}$ | Eq.(3b) | $225.5[\mu m]$ |

**Claims**

1. A two axes MEMS resonant magnetometer (1) comprising in one plane a freestanding rectangular frame (2) having inner walls (3,4) and 4 torsion springs (5,6,7,8), wherein opposing inner walls (3,4) of the frame are contacted by one end (5a,6a,7a,8a) of only 2 springs, each spring being anchored by its other end (5b,6b,7b,8b) to a substrate (9).

2. The MEMS magnetometer according to claim 1, wherein the magnetometer is configured to operate, when in use, in two orthogonal sensing modes.

3. The MEMS magnetometer according to any of the foregoing claims, wherein the substrate (9) comprises two electrically isolated power supply lines (10,11) and whereby diagonally facing anchored (5b,7b) (6b,8b) ends are electrically connected to the same power supply line (10)(11).

4. The MEMS magnetometer according to any of the foregoing claims, wherein the substrate (9) comprises 4 electrodes (12,13,14,15), each electrode being capacitively coupled to a different side (16,17,18,19) of the frame (2) thereby forming 4 capacitors, whereby the 4 electrodes are configured for differential capacitive measurement between opposite capacitors (14-17,12-19) (13-16,15-18).

5. The MEMS magnetometer according to any of the foregoing claims, wherein the rectangular frame (2) and the torsion springs (5,6,7,8) are formed in a single layer of the same material.

6. The MEMS magnetometer according to claim 5, wherein the material is metal.

7. The MEMS magnetometer according to any of the foregoing claims wherein the torsion springs are L-shaped and the other ends (5b,6b,7b,8b) of each spring are anchored towards the centre of the frame, to a substrate (9).

8. A method for designing a MEMS magnetometer according to any of the claims 4 to 7, comprising: dimensioning the frame (2) and the torsion springs (5,6,7,8) to maximize the sensitivity of the differential capacitive measurement between opposite capacitors (14-17,12-19) (13-16,15-18), while minimizing the cross-sensitivities of the differential capacitive measurement between adjacent capacitors.

9. A method for operating a MEMS magnetometer according to any of the claims 4 to 7, comprising:

- placing the MEMS magnetometer in an magnetic field,
- applying an AC voltage between the two power supply lines (10, 11), the AC voltage having a frequency equal to the frequency of at least one of the two orthogonal modes of the MEMS magnetometer, thereby creating a current flowing between opposite biased anchored ends,
- measuring the differential capacitance between opposite capacitors (14-17,12-19) (13-16,15-18) corresponding to the orthogonal mode, and
- determining from this differential capacitance measurement an in-plane component of the magnetic field.

**Patentansprüche**

1. Ein MEMS Resonanz- Magnetometer (1) bestehend in einer Ebene aus einem freistehenden, rechteckigen Rahmen (2), mit Innenwänden (3, 4) und 4 Torsionsfedern (5, 6, 7, 8), wobei gegenüberliegende Innenwände (3,4) des Rahmens von einem Ende (5a, 6a, 7a, 8a) von nur 2 Federn berührt werden, und jede Feder mit dem anderen Ende (5b, 6b, 7b, 8b) mit einem Träger (9) verankert ist.

2. Der MEMS Magnetometer gemäß Anspruch 1, wobei der Magnetometer so konfiguriert ist, dass er bei Benutzung in zwei orthogonalen Abtastmodi arbeitet.

3. Der MEMS Magnetometer gemäß irgendeinem der vorangehenden Ansprüche, wobei der Träger (9) zwei elektrisch isolierte Stromversorgungsleitungen (10,11) beinhaltet und wobei diagonal einander gegenüberliegende Verankerungsendstücke (5b, 7b) (6b, 8b) elektrisch mit derselben Stromversorgungsleitung (10) (11) verbunden werden.

4. Der MEMS Magnetometer gemäß irgendeinem der vorangehenden Ansprüche, wobei der Träger (9) 4 Elektroden (12, 13, 14, 15), enthält und jede Elektrode kapazitiv gekoppelt ist an eine andere Seite (16, 17, 18, 19) des Rahmens (2) und damit 4 Kondensatoren bilden, wobei die 4 Elektroden für verschiedene kapazitive Messungen zwischen gegenüberliegenden Kondensatoren (14-17,12-19) (13-16,15-18) konfiguriert sind.

5. Der MEMS Magnetometer gemäß irgendeinem der vorangehenden Ansprüche, wobei der rechteckige Rahmen (2) und die Torsionsfedern (5, 6, 7, 8) aus einer einzigen Schicht desselben Materials geformt sind.

6. Der MEMS Magnetometer gemäß Anspruch 5, wobei es sich bei dem Material um Metall handelt.

7. Der MEMS Magnetometer gemäß irgendeinem der vorstehenden 5 Ansprüche, wobei die Torsionsfedern L-förmig sind und die anderen Enden (5b, 6b, 7b, 8b) jeder Feder in Richtung Rahmenmitte mit einem Träger (9) verankert sind.

**8.** Eine Methode zum Entwurf eines MEMS Magnetometer gemäß irgendeinem der vorstehenden Ansprüche 4 bis 7, bestehend aus :

Bemessung des Rahmens (2) und der Torsionsfedern (5, 6, 7, 8) zur Maximierung der Empfindlichkeit der kapazitiven Differenzmessung zwischen gegenüberliegenden Kondensatoren (14-17,12-19) (13-16,15-18), bei Minimierung der Querempfindlichkeiten der Differenzmessung zwischen benachbarten Kondensatoren.

**9.** Eine Methode zum Betrieb eines MEMS Magnetometer gemäß irgendeinem der vorstehenden Ansprüche 4 bis 7, bestehend aus :

- MEMS Magnetometer in ein magnetisches Feld stellen,
- eine Wechselspannung zwischen den beiden Stromversorgungsleitungen (10, 11) anlegen, wobei die Frequenz der Wechselspannung gleich ist der Frequenz mindestens einer der beiden orthogonalen Modi des MEMS Magnetometer, wodurch ein ständiger Strom zwischen den gegenüberliegenden, einseitig verankerten Enden erzeugt wird,
- Messung der Differentialkapazität zwischen entgegengesetzten Kondensatoren (14-17,12-19) (13-16,15-18) entsprechend dem orthogonalen Modus, und
- Bestimmung anhand der kapazitiven Differenzmessung einer Komponente in der Ebene des Magnetfeldes.

**Revendications**

**1.** Magnétomètre résonant MEMS à deux axes (1) comprenant dans un plan un châssis rectangulaire indépendant (2) ayant des parois intérieures (3, 4) et 4 ressorts de torsion (5, 6, 7, 8), dans lequel des parois intérieures opposées (3, 4) du châssis sont en contact avec une extrémité (5a, 6a, 7a, 8a) de seulement 2 ressorts, chaque ressort étant ancré par son autre extrémité (5b, 6b, 7b, 8b) à un substrat (9).

**2.** Magnétomètre MEMS selon la revendication 1, dans lequel le magnétomètre est configuré pour fonctionner, quand on l'utilise, dans deux modes de détection orthogonaux.

**3.** Magnétomètre MEMS selon n'importe laquelle des revendications précédentes, dans lequel le substrat (9) comprend deux lignes d'alimentation en énergie électriquement isolées (10, 11) et par lesquelles les extrémités (5b, 7b) (6b, 8b) ancrées se faisant face en diagonale sont électriquement reliées à la même ligne d'alimentation en énergie (10) (11).

**4.** Magnétomètre MEMS selon n'importe laquelle des revendications précédentes, dans lequel le substrat (9) comprend 4 électrodes (12, 13, 14, 15), chaque électrode étant couplée de manière capacitive à un côté différent (16, 17, 18, 19) du châssis (2) formant ainsi 4 condensateurs, de sorte que les 4 électrodes sont configurées pour une mesure capacitive différentielle entre des condensateurs opposés (14-17, 12-19) (13-16, 15-18).

**5.** Magnétomètre MEMS selon n'importe laquelle des revendications précédentes, dans lequel le châssis rectangulaire (2) et les ressorts de torsion (5, 6, 7, 8) sont formés dans une couche unique de la même matière.

**6.** Magnétomètre MEMS selon la revendication 5, dans lequel la matière est du métal.

**7.** Magnétomètre MEMS selon n'importe laquelle des revendications précédentes, dans lequel les ressorts de torsion sont en forme de L et les autres extrémités (5b, 6b, 7b, 8b) de chaque ressort sont ancrées vers le centre du châssis, à un substrat (9).

**8.** Procédé pour concevoir un magnétomètre MEMS selon n'importe laquelle des revendications 4 à 7, comprenant : le dimensionnement du châssis (2) et des ressorts de torsion (5, 6, 7, 8) pour maximiser la sensibilité de la mesure capacitive différentielle entre des condensateurs opposés (14-17, 12-19) (13-16, 15-18), tout en minimisant les sensibilités croisées de la mesure capacitive différentielle entre des condensateurs adjacents.

**9.** Procédé pour mettre en oeuvre un magnétomètre MEMS selon n'importe laquelle des revendications 4 à 7, comprenant :

- le placement du magnétomètre MEMS dans un champ magnétique,

- l'application d'une tension alternative entre les deux lignes d'alimentation en énergie (10, 11), la tension alternative ayant une fréquence égale à la fréquence d'au moins un des deux modes orthogonaux du magnétomètre MEMS, créant ainsi un courant s'écoulant entre des extrémités ancrées polarisées opposées,
- la mesure de la capacité différentielle entre des condensateurs opposés (14-17, 12-19) (13-16, 15-18) correspondant au mode orthogonal, et
- la détermination à partir de cette mesure de capacité différentielle d'une composante dans le plan du champ magnétique.

Figure 1

Figure 2

Figure 3

Figure 4

Figure 5

Figure 6(A)

**Figure 6(B)**

**Figure 7**

Figure 8

Figure 9(B)

Figure 9(A)

Figure 10(A)

Figure 10(B)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LI et al.** Three-Axis Lorentz-Force Magnetic Sensor for Electronic Compass Applications. *IEEE journal of microelectromechanical systems,* August 2012, vol. 21 (4